# EUROPEAN PATENT APPLICATION

(11) **EP 1 589 801 A2**
(43) Date of publication of application: **26.10.2005**
(21) Application number: 05251623.4
(22) Date of filing: 17.03.2005
(51) Int. Cl.: H05K 9/00

(54) **Electromagnetic wave shielding structure**

(30) Priority: 22.03.2004 JP 2004082846
(71) Applicant: Ohtsuka Co., Ltd., Shinagawa-ku Tokyo (JP)
(72) Inventor: Shimoda, Akio, c/o Ohtsuka Co., Ltd., Tokyo (JP)
(74) Representative: Hammersley, John

(57) **Abstract**

The present invention provides an electromagnetic wave shielding structure for shielding electromagnetic waves emitted from a harness of electrical equipment. For example, a vehicle body of an electric vehicle is provided with a direct current power source, an inverter, and a driving motor. The direct current power source and the inverter, and the inverter and the driving motor are connected to each other by harnesses, respectively. Around the harnesses, cylindrical members for shielding electromagnetic waves are provided, respectively, so as to cover the harnesses. The peripheral wall of the cylindrical member made of aluminum, on which an uneven portion is formed continuously in the axial direction, shields electromagnetic waves emitted from the harness to the outside.

## Description

### BACKGROUND OF THE INVENTION AND RELATED ART STATEMENT

### 1. Field of the Invention

The present invention relates to an electromagnetic wave shielding structure for shielding electromagnetic waves emitted from a power supply harness or a signal harness of electrical equipment.

### 2. Description of Related Art

While automobiles are often mounted with electrical (electronic) equipment, such as audio and video products, many noise generating sources are also present, such as an alternator and a fuel pump. Although an audio product, such as a radio, is usually provided with a circuit for noise suppression, noise is sometimes generated from the audio product due to manufacture error of the automobile or radio interference in a region. Therefore, noise is suppressed by various methods as described below.

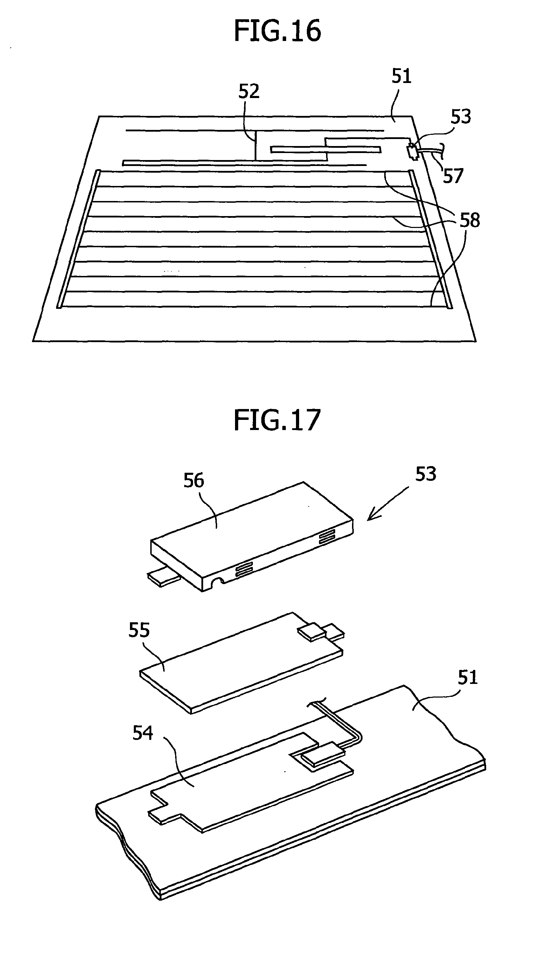

For example, according to Japanese Patent Provisional Publication No. 6-291529 (hereinafter referred to as Patent Document 1), as shown in FIG. 16, a radio glass antenna 52 is embedded in a rear glass 51 of an automobile. Unlike a rod antenna, the glass antenna 52 has weak receiving sensitivity, so that an antenna booster 53 must be mounted. As shown in FIG. 17, the antenna booster 53 includes a conductive pad 54, a circuit board 55 disposed on the surface of the conductive pad 54, and a metallic case 56 for shielding these elements, and is connected with an aerial wire 57 for a radio (not shown). The metallic case 56 acts as a case for covering the circuit board 55 and serves a role in shielding electromagnetic waves intruding into the circuit board 55 from the outside by being earthed to the vehicle body side. In FIG. 16, reference numeral 58 denotes a heating wire for preventing the rear glass 51 from fogging up.

Due to the influence of emission controls as a consequence of recent global warming, the motive force for automobiles is moving away from the gasoline engine to a clean engine such as that in electric vehicles. Although an electric vehicle is mounted with an alternating current electric motor as a prime mover, the power source mounted on an automobile is a direct current battery. Therefore, the direct current is converted into alternate current by using an inverter to drive an alternating current electric motor. At this time, electromagnetic waves causing radio interference to an audio product are generated due to the switching operation for converting electricity.

According to Japanese Patent Provisional Publication No. 2003-285002 (hereinafter referred to as Patent Document 2), as shown in FIG. 18, an inverter cover 62 is used to shield the electromagnetic waves emitted from the inverter 61 itself. The inverter cover 62 is formed as a three-layer structure in which a conductive coating film 63, an aluminum sheet 64, and a resin coating 65 are lapped on each other in this order from the inside to the outside, and shields or alleviates electromagnetic waves emitted from the inverter 61.

An electric vehicle uses a direct current power source of 200 V or higher because it requires a great driving force, and on the other hand, a gasoline-fueled vehicle uses a conventional direct current power source of 12 V (24 V for a truck). Many types of electrical equipment mounted on the electric vehicle are conventional electrical equipment for 12 V power source, so that the battery voltage must be lowered by using a DC-DC converter.

According to Japanese Patent Provisional Publication No. 2001-352636 (hereinafter referred to as Patent Document 3), an electric vehicle is provided with two systems of direct current power sources of, for example, a high voltage of 42 V and a low voltage of 12 V. In the case where two systems, high and low, of electronic circuits are used as described above, the electronic circuit of low voltage is liable to be affected by noise generated from the electronic circuit of high voltage. According to the technique disclosed in this Publication, as shown in FIG. 19, a harness 71 of low voltage such as an audio product is covered with a conductive member 72 having a semi-arc shaped cross section, and a harness 73 of high voltage such as a power window is disposed on the outer periphery side of the conductive material 72. The harness 73 is fixed to the conductive member 72 by winding a tape 74 around these elements, and mounting elements 75 for the conductive member 72 are earthed to a side sill 76 of the vehicle body for earthing. Thus, the low-voltage harness 71 shields electromagnetic waves emitted from the high-voltage harness 73 to prevent noise from being generated from the audio product.

### OBJECT AND SUMMARY OF THE INVENTION

According to Patent Document 1, as shown in FIG. 17, the metallic case 56 is earthed to prevent noise. However, in the case where a distance between the rear glass 51 and a radio mounted on a front instrument panel of vehicle body is long, or in the case where the earthing of the vehicle body is incomplete, a potential difference is produced between the earths of the radio and the antenna booster. If a slight potential difference exists between the earths, an influence of electromagnetic waves emitted from the outside is liable to be exerted, and the radio is in an environment subject to noise. A harness for the aforementioned fuel pump is extended from the front side of vehicle body to the rear like the aerial wire for the radio. Therefore, in the case where the harness generates electromagnetic waves, the electromagnetic waves intrude into the aerial wire 57, and are transmitted to the radio through an antenna cord, so that the radio amplifies the electromagnetic waves, and noise is generated from a speaker.

For the video equipment such as a television set as well, if electromagnetic wave noise intrudes, linear noise appears on the scanning line in the transverse direction of the screen, so that as in the case of the audio equipment, measures against noise must be taken to prevent radio interference from electromagnetic waves. Although electromagnetic waves intruding from the aerial wire have been explained, electromagnetic waves sometimes intrude directly into the power source harness or body circuit of audio equipment etc. to create noise.

According to Patent Document 2, as shown in FIG. 18, the inverter 61 is covered with the inverter cover 62 to shield the release of electromagnetic waves. With this method, although the electromagnetic waves from the body of the inverter 61 can be shielded, in some cases, electromagnetic waves are also generated from a harness between the inverter 61 and an automotive battery or a harness between the inverter 61 and a driving motor. In this case, it is impossible to effectively protect the electrical equipment generating noise from the electromagnetic waves.

According to Patent Document 3, as shown in FIG. 19, although the low-voltage harness 71 is covered with a conductive member 72, electromagnetic waves sometimes intrude directly into the body of electrical equipment from the high-voltage harness 73 disposed on the outside of the conductive member 72. In the case where high-frequency waves having a short wavelength intrude into a gap of the back surface of an object or electromagnetic waves are emitted from a harness, great electromagnetic waves are generated in a portion near the electrical equipment of harness. Therefore, the noise treatment in a connecting portion between the harness and the electrical equipment is an important point for alleviating noise.

The present invention has been made in view of the above-described circumstances, and accordingly an object thereof is to provide an electromagnetic wave shielding structure which shields electromagnetic waves emitted from a harness of electrical equipment, and shields electromagnetic waves emitted from a connecting portion between the electrical equipment and the harness connected to the electrical equipment.

In the present invention, a cylindrical member is provided around a harness connected to electrical equipment, and the peripheral wall of the cylindrical member is formed in a corrugated shape in the axial direction. The cylindrical member can be made of a metal.

In the present invention, the cylindrical member is formed in two or more layers, and the layers of the cylindrical member can be bonded with a conductive adhesive.

In the present invention, the configuration can be such that a cylindrical end connection is formed in a pull-out port portion for a harness of the electrical equipment, and the end part of the cylindrical member is fitted on the outer peripheral surface of the end connection, by which the harness and the pull-out port portion are connected to each other.

Also, in the present invention, the configuration can be such that a cylindrical inside end connection and an outside end connection are formed in a pull-out port portion for a harness of the electrical equipment, and the end part of the cylindrical member is inserted between the inside end connection and the outside end connection, by which the harness and the pull-out port portion are connected to each other.

In the present invention, the cylindrical member can have flexibility, and also the cylindrical member can be made of aluminum.

In the present invention, the conductive adhesive can contain at least one kind of epoxy, urethane, acrylic, and polyester-based resins. Also, the cylindrical member can be provided around the harness for connecting a battery for an electric vehicle to an inverter for converting a direct current into an alternating current and/or for connecting the inverter to a driving motor for the electric vehicle.

### BRIEF DESCRIPTION OF THE DRAWINGS

FIG. 1 is a plan view of an automobile which adopts an electromagnetic wave shielding structure in accordance with an embodiment of the present invention;
FIG. 2 is a perspective view of a cylindrical member for shielding electromagnetic waves in accordance with an embodiment of the present invention;
FIG. 3A is a partially sectioned side view of the cylindrical member shown in FIG. 2, and FIG. 3B is a front view of the cylindrical member;
FIG. 4A is an enlarged sectional view of a three-layer cylindrical member indicated by the arrow X in FIG. 3A, FIG. 4B is a sectional view of a three-layer cylindrical member of a modified example, and FIG. 4C is a sectional view of a five-layer cylindrical member of another modified example;
FIG. 5 is a partially broken side view of a connecting portion (end connection has a single structure) between a cylindrical member and an inverter in accordance with the present invention;
FIG. 6 is a front view of the connecting portion of an inverter shown in FIG. 5;
FIG. 7 is a partially broken side view of a connecting portion (end connection has a double structure) between a cylindrical member and an inverter in accordance with the present invention;
FIG. 8 is a front view of the connecting portion of an inverter shown in FIG. 7;
FIG. 9A is a sectional view showing a state in which a cylindrical member is attached to an inverter by using a staking element and a connecting element, FIG. 9B is a sectional view showing a state in which a cylindrical member is attached to an inverter by using a nipple, and FIG. 9C is a sectional view showing a state in which a cylindrical member is attached to an inverter by using a flanged nipple;
FIG. 10 is a side view of a cylindrical member showing a state in which an earth bond wire is connected to the cylindrical member in accordance with this embodiment;
FIG. 11 is a schematic view showing a testing method for measuring electromagnetic wave shielding performance of a cylindrical member in accordance with this embodiment;
FIG. 12 is a schematic view showing a testing method for measuring electromagnetic waves of a harness only in the case where the cylindrical member shown in FIG. 11 is not used;
FIG. 13 is a graph of electromagnetic wave shielding performance;
FIG. 14 is a view showing a state in which electromagnetic waves are reflected on a surface of a curved uneven portion of a cylindrical member in accordance with this embodiment;
FIG. 15 is a side view showing a modification of a method for attaching an end connection of an inverter to an end part of a cylindrical member;
FIG. 16 is a back view showing a state in which an antenna booster is installed to a window glass of an automobile in accordance with a conventional example;
FIG. 17 is an exploded perspective view of the antenna booster shown in FIG. 16;

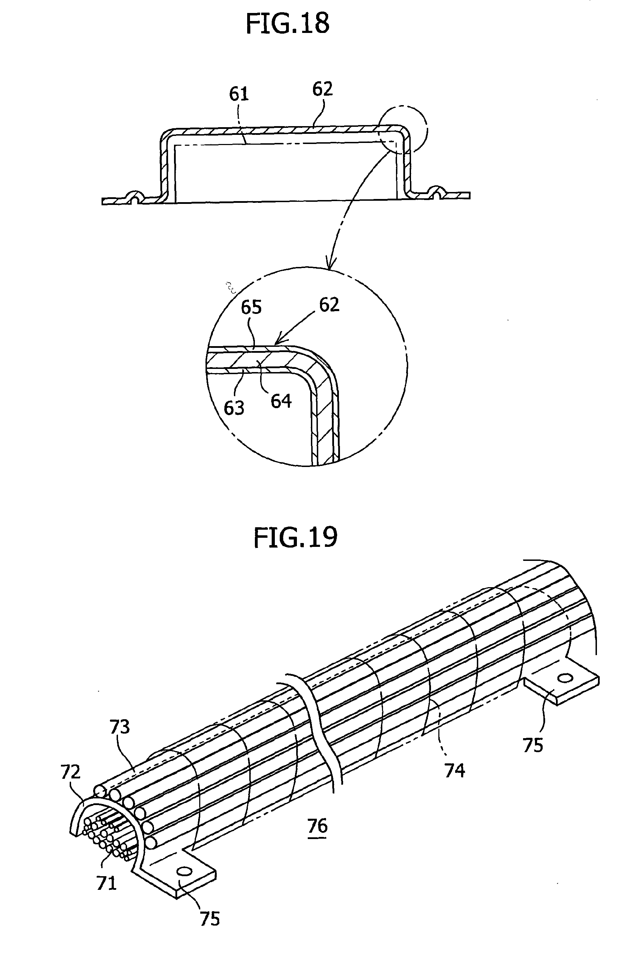

FIG. 18 is a sectional view showing a state in which an inverter is shielded by being covered with a shield member in accordance with a conventional example; and
FIG. 19 is a perspective view showing a state in which a harness is covered with a shield member in accordance with a conventional example.

### DETAILED DESCRIPTION OF PREFERRED EMBODIMENTS

An electromagnetic wave shielding structure in accordance with an embodiment of the present invention will now be described with reference to the accompanying drawings.

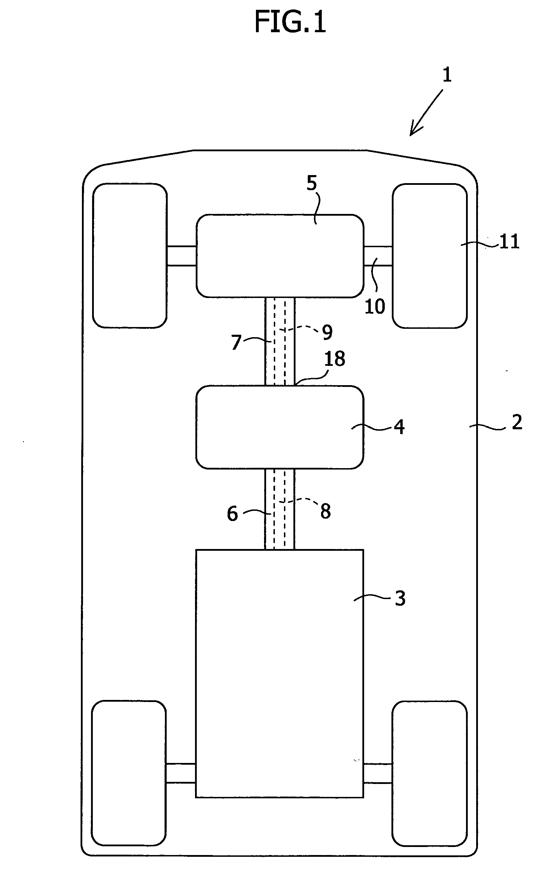

FIG. 1 is a schematic plan view of an electric vehicle 1. On a vehicle body 2 of the electric vehicle 1, there are arranged a high-voltage direct current power source 3 in which many batteries are disposed, an inverter 4 for converting the direct current into an alternating current, and a driving motor 5 which is driven by the alternating current power source converted by the inverter 4. Between the direct current power source 3 and the inverter 4, a cylindrical member 6 is connected, and between the inverter 4 and the driving motor 5, a cylindrical member 7 is connected. In one cylindrical member 6, a harness 8 for connecting the direct current power source 3 to the inverter 4 is disposed, and in the other cylindrical member 7, a harness 9 for connecting the inverter 4 to the driving motor 5 is disposed. The driving motor 5 transmits a driving force to driving wheels 11 via a transaxle, not shown, and a driving shaft 10 to run the electric vehicle 1.

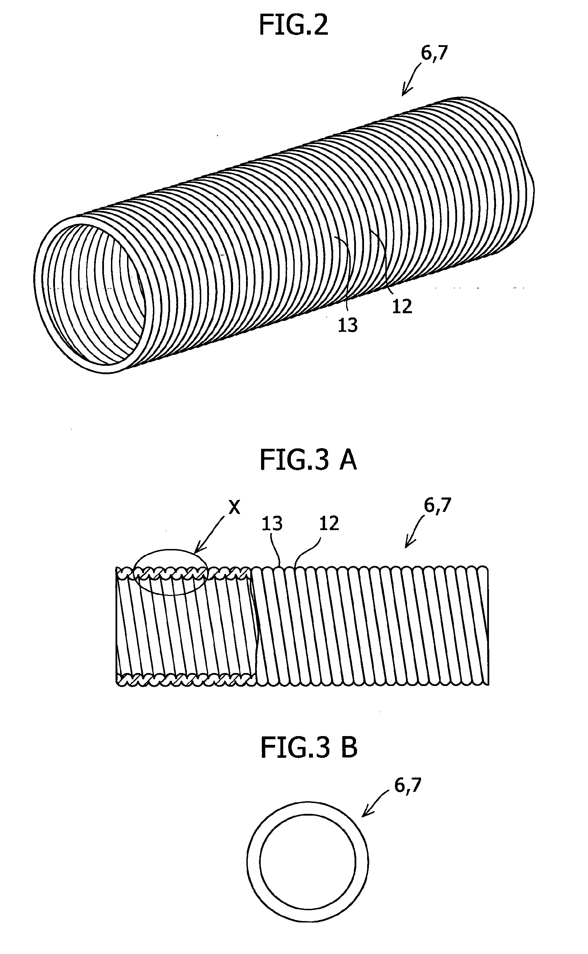

FIG. 2 is a perspective view of the cylindrical member. FIG. 3A is a side view of the cylindrical member, and FIG. 3B is a front view in which the cylindrical member is viewed in the axial direction. In the figures, a shortened cylindrical member 6, 7 is shown, but the actual shape thereof is so long in the axial direction as to be capable of connecting the direct current power source 3 to the inverter 4. The cylindrical member 6, 7 has a circular cross section, and is configured so that a corrugated uneven portion 12, 13 is formed on the whole surface of a peripheral wall in the axial direction, the uneven portion 12, 13 being formed in a spiral form around the axis. Since the cylindrical member 6, 7 has flexibility, the shape of its axis can be bent freely into an S shape, a U shape, or other shapes.

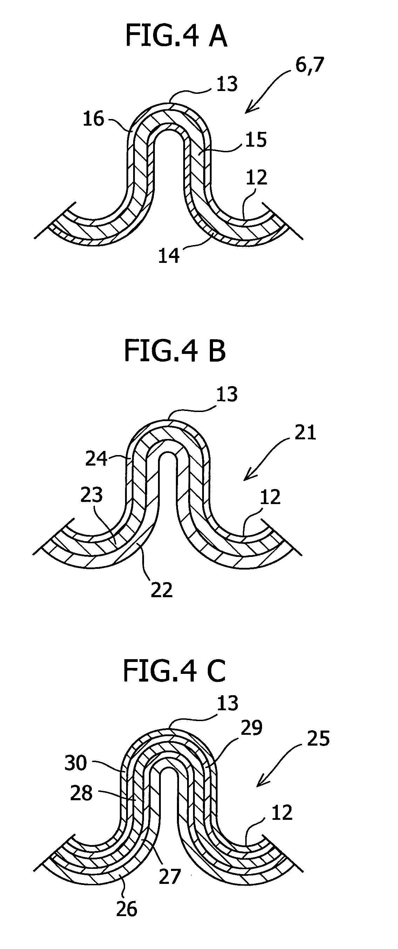

FIG. 4A is a partially enlarged view of a portion indicated by the circle X in FIG. 3A.

The peripheral wall part of the cylindrical member 6, 7 has a multilayer structure. FIG. 4A shows a three-layer structure in which an internal layer material 14 is aluminum, an intermediate layer material 15 is, for example, a conductive material, and an external layer material 16 is aluminum. As the internal and external layer materials 14 and 16, a band-shaped aluminum foil is used, and as the intermediate layer material 15, a band-shaped carbon kraft paper having conductivity or the like is used. These layer materials 14 to 16 are bonded to each other by an adhesive having conductivity. The aluminum foil has a width of 24 to 120 mm and a thickness of 0.03 to 0.15 mm.

By winding the aforementioned band-shaped materials in a spiral form, the cylindrical member 6, 7 can be formed so as to have an arbitrary length. On the surface of the cylindrical member 6, 7, the uneven portion 12, 13 is formed. The uneven portion 12, 13 may be formed in a spiral shape, or a ring-shaped uneven portion 12, 13 may be formed continuously.

The cylindrical member 6, 7 may be formed by lapping the facing edges of sheets of the internal and external layer materials 14 and 16 and the intermediate layer material 15 on each other, not by winding the band-shaped materials in a spiral form. As the internal and external layer materials 14 and 16, not only aluminum but also a band-shaped material of iron, stainless steel, copper, etc. can be used. However, these materials have a thickness of 0.03 to 0.10 mm, and other shapes thereof are the same as those of aluminum.

The conductive adhesive contains a conductive resin in which a metal or carbon is blended with a resin being a base, and various kinds of products thereof have already been on the market. As the base resin, epoxy, urethane, acrylic, or polyester resin can be used, and as conductive particles, gold, silver, nickel, carbon, etc. can be used.

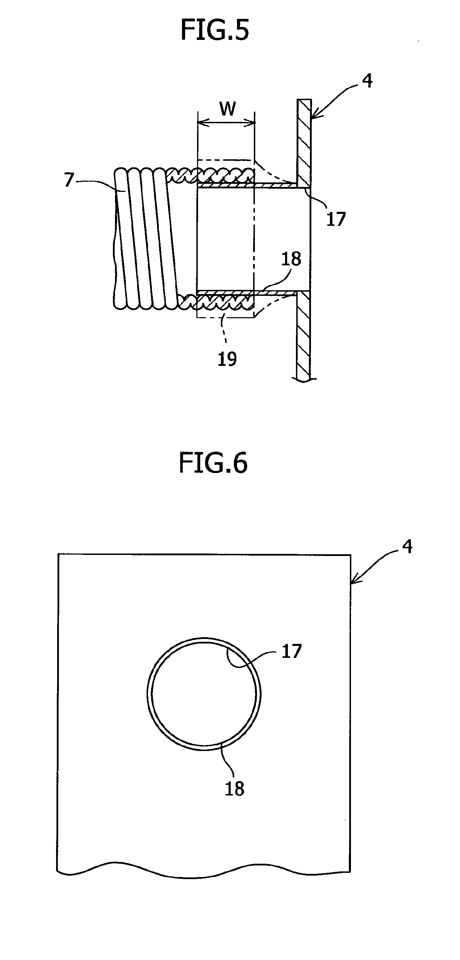

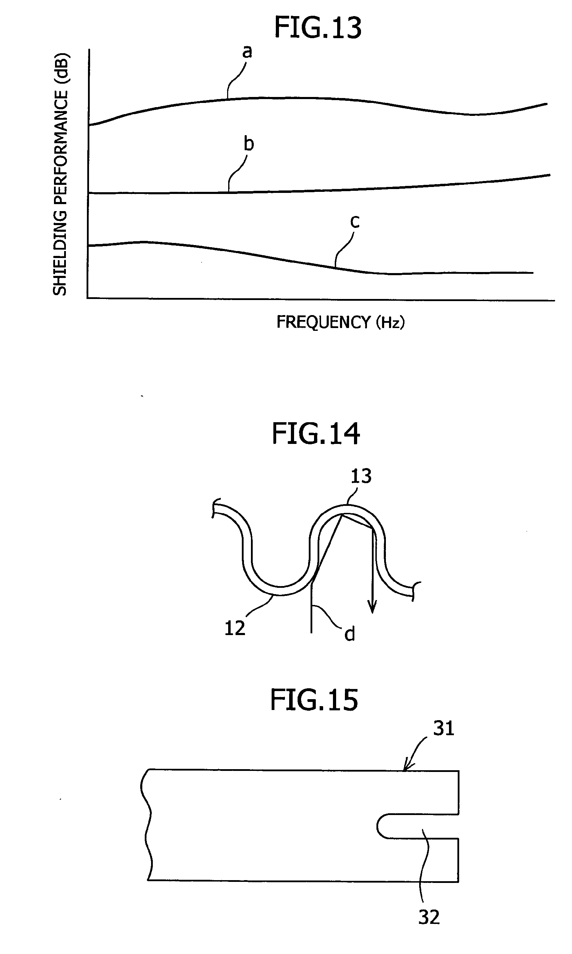

FIGS. 5 and 6 show a connecting portion between a pull-out port 17 for a harness 9 of the inverter 4 and the cylindrical member 7. At the pull-out port 17, a cylindrical end connection 18 is formed so as to protrude from a casing of the inverter 4 to the outside. The end connection 18 is molded integrally with the casing of the inverter 4. In the case where the end connection 18 is an element separate from the casing of the inverter 4, the end connection 18 is formed of a material capable of being earthed to the vehicle body 2. The outside diameter of the end connection 18 is equal to the inside diameter of the cylindrical member 7, so that the cylindrical member 7 can be connected to the end connection 18 by fitting the former on the latter. A clearance between the cylindrical member 7 and the end connection 18 is made as small as possible, and an overlap width W of these elements of 10 mm or greater is preferably secured. Regarding the fixing method, a tape 19 may be wound as shown in FIG. 15, or a conductive adhesive may be used. Also, a portion of the overlap width W can be tightened from the outer periphery side of the cylindrical member by using a band. Although explanation has been given taking the connecting portion between the inverter 4 and the cylindrical member 7 as an example, an end connection between the cylindrical member 6 and the direct current power source 3 or the inverter 4 and an end connection between the cylindrical member 7 and the driving motor 5 can be fixed in the same way.

Since the harness 9 is shielded by the cylindrical member 7 as described above, even if electromagnetic waves are emitted from the harness 9, the leakage of electromagnetic waves can be alleviated by the cylindrical member 7. Also, the leakage of the electromagnetic waves that are going to intrude into a gap between the cylindrical member 7 and the end connection 18 can be reduced because the gap therebetween is eliminated. Also, since the cylindrical member 7 has high heat insulating properties, the harness 9 can be protected from heat.

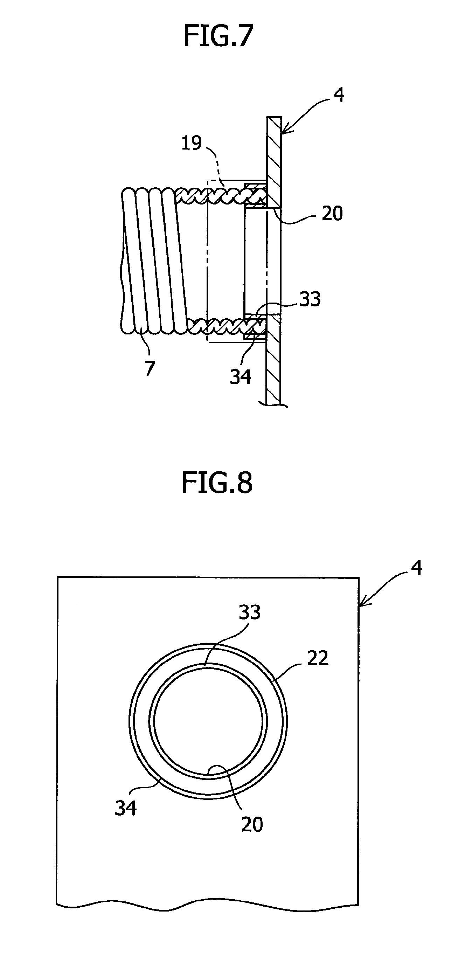

FIGS. 7 and 8 show an example in which an end connection having a double-wall structure is formed at a pull-out port 20 for the harness 9 of the inverter 4. The outside diameter of an inside end connection 33 is equal to the inside diameter of the cylindrical member 7, and the inside diameter of an outside end connection 34 is equal to the outside diameter of the cylindrical member 7. Therefore, the end part of the cylindrical member 7 can be inserted between the inside and outside end connections 33 and 34. The cylindrical member 7 is fixed to the end connections 33 and 34 by using the tape 19 or a conductive adhesive. Other constructions are the same as those of the aforementioned end connection 18.

The configuration described above can also alleviate electromagnetic waves emitted from the harness and reduce the leakage of the electromagnetic waves that are going to intrude into gaps between the cylindrical member 7 and the end connections 33 and 34.

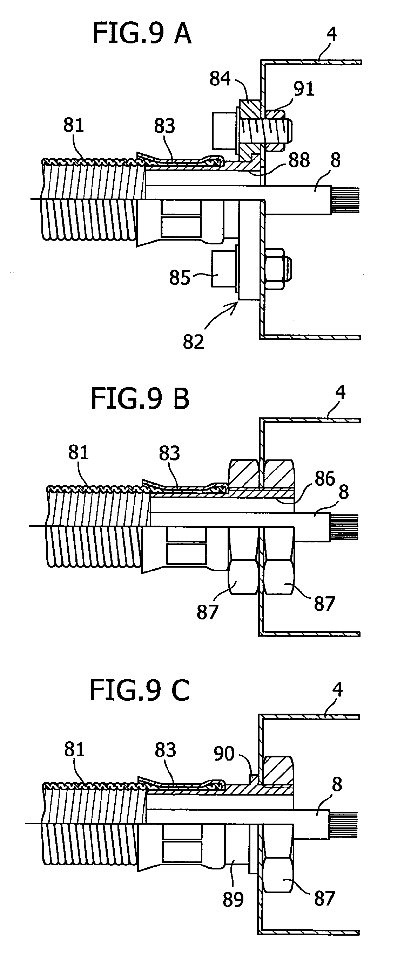

FIGS. 9A to 9C show a connecting method carried out by staking.

In FIG. 9A, the end part of a cylindrical member 81 is fitted to the outer periphery of a cylindrical part 88 of a connecting element 82, and a staking element 83 is disposed at the outer periphery of the cylindrical member 81, by which staking joint is accomplished. Then, a flange part 84 formed on the connecting element 82 is fastened to the inverter 4 with bolts 85 and nuts 91, by which the cylindrical member 81 is attached to the inverter 4.

In FIG. 9B, the end part of the cylindrical member 81 is fitted to the outer periphery of a nipple 86, and the staking element 83 is disposed at the outer periphery of the cylindrical member 81, by which staking joint is accomplished. Then, a threaded part formed on the nipple 86 is inserted into the inverter 4, and the nipple 86 is fastened to the inverter 4 from the inside and outside of the inverter 4 with nuts 87, by which the cylindrical member 81 is attached to the inverter 4.

In FIG. 9C, the end part of the cylindrical member 81 is fitted to the outer periphery of a nipple 89 provided with a flange 90, and the staking element 83 is disposed at the outer periphery of the cylindrical member 81, by which staking joint is accomplished. Then, the tip end part of the nipple 89 is inserted until the flange 90 abuts on the inverter 4, and the nipple 89 is fastened to the inverter 4 from the inside of the inverter 4 with the nut 87, by which the cylindrical member 81 is attached to the inverter 4.

The configurations described above can also alleviate electromagnetic waves emitted from the harness 8 and reduce the leakage of electromagnetic waves from the connecting portion between the cylindrical member 81 and the inverter 4.

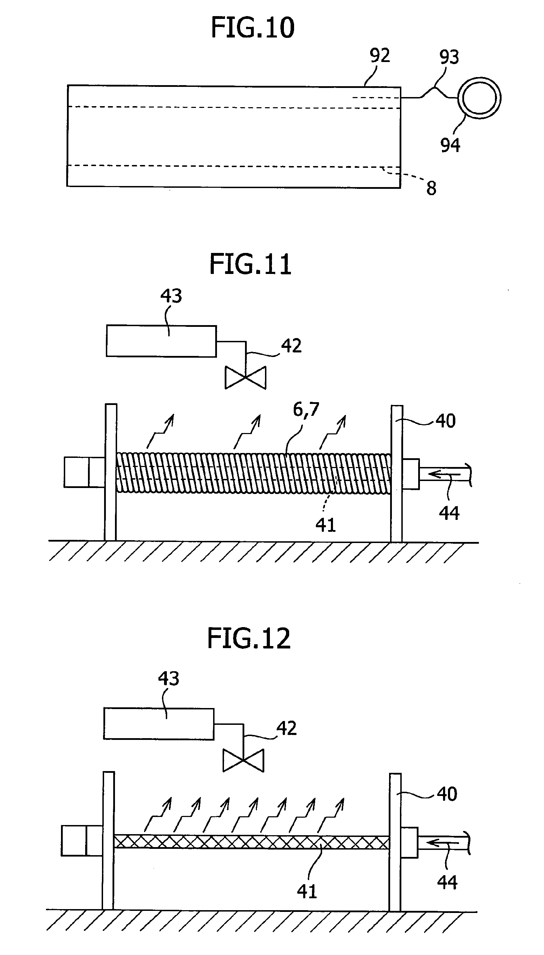

FIG. 10 shows a state in which an earth bond wire 93 is connected to a cylindrical member 92. A terminal 94 attached to the end part of the earth bond wire 93 is attached to a body earth of vehicle body or a portion corresponding to the body earth. In this case, it is preferable that the casing for the inverter 4 be likewise earthed by an earth bond wire. In the case where the emission of electromagnetic waves is caused by poor earth, the emission of electromagnetic waves can effectively alleviated or prevented. The earth bond wire may be extended from one end part of the cylindrical member 92 to the other end part thereof.

FIG. 11 shows a testing method for measuring electromagnetic wave shielding performance of the cylindrical member 6, 7 (hereinafter, reference numeral 7 is merely used) in accordance with this embodiment, and FIG. 12 shows a testing method for measuring electromagnetic waves of a harness 41 without the use of a cylindrical member.

As shown in FIG. 11, the cylindrical member 7 is supported between support members 40, and the harness 41 emitting electromagnetic waves 44 is shielded from the outside by the cylindrical member 7. Electromagnetic waves were caused to flow in the harness 41, and leak electromagnetic waves were received by an antenna 42, by which the receiving intensity was measured by a receiver. The shielded portion of the harness 41 has a length of 1 m, and the harness 41 has an outside diameter of 5 mm. In FIG. 12, the cylindrical member 7 is removed from the testing apparatus shown in FIG. 11 to make the harness 41 a simple body. FIG. 12 shows the emission source of electromagnetic waves, which forms the basis.

For comparison, a different aluminum cylindrical member which is not formed with an uneven portion and shields the harness 41 under the same conditions as those of the cylindrical member 7 in accordance with the above-described embodiment and a member subjected to braid-type shielding around the harness 41 were prepared.

The test result is shown in the graph FIG. 13. The ordinate axis represents shielding performance (dB), showing a difference between the amount of emission of electromagnetic waves from the simple body of cable and the amount of electromagnetic waves emitted from the cylindrical member 7 (and members under test). The abscissa axis represents frequency (Hz). In the figure, reference character a denotes the cylindrical member 7, b denotes the aluminum cylindrical member not formed with the uneven portion, and c denotes the braid-type shielded member. The cylindrical member 7 exhibited high shielding performance, the cylindrical member formed of aluminum only was inferior in shielding performance to the cylindrical member 7, and the braid-type shielded member exhibited poor shielding performance. The reason why the cylindrical member 7 exhibits high shielding performance is thought to be that in addition to the shielding performance of the metal itself that confines electromagnetic waves, as shown in FIG. 14, electromagnetic waves damp while the electromagnetic waves are reflected on the uneven portion 12, 13 and ideal reflection (reflected and cancelled each other) d is repeated. It is necessary that as the pitch and height of the uneven portion 12, 13, numerical values for which the ideal reflection is carried out be selected.

If the pitch from the concave part 12 to the concave part 12 (or from the convex part 13 to the convex part 13) of the cylindrical member 7 shown in FIG. 4A is set at 4 mm or smaller, and the height from the concave part 12 to the convex part 13 is set at 0.5 mm or larger, a greater damping effect can be obtained. Comparing the multi-layer cylindrical member with a single-layer cylindrical member, the amount of electromagnetic waves intruding and emitted from the connecting portion is smaller for the multi-layer cylindrical member. The reason for this is thought to be that the large thickness of the cylindrical member reduces the amount of electromagnetic waves intruding into the connecting portion.

As described above, by covering the harness emitting electromagnetic waves with the cylindrical member 7, the emission of electromagnetic waves is alleviated, and hence the occurrence of noise in the audio equipment or video equipment is prevented. Since the cylindrical member 7 has a large thickness, by bringing the connecting portion in the end part into contact, electromagnetic waves can be prevented from leaking from the gap in the connecting portion.

The above is a description of one embodiment of the present invention. Needless to say, the present invention is not limited to the above-described embodiment, and various changes and modifications can be made based on the technical concept of the present invention.

For a cylindrical member 21 shown in FIG. 4B, the same kind of metals such as aluminum foil or different kinds of metals such as aluminum foil and copper foil etc. are used as an internal layer material 22 and an intermediate layer material 23, and either a conductive material or an insulating material is used as an external layer material 24. The cylindrical member 25 shown in FIG. 4C has a five-layer structure in which an internal layer material 26, first to third intermediate layer materials 27 to 29, and an external layer material 30 are lapped in succession from the inside. Of these materials, the internal layer material 26 and the second intermediate material 28 are aluminum foil, and the first intermediate layer material 27, the third intermediate material 29, and the external layer material 30 each are a conductive material or an insulating material. The layer materials other than aluminum are band-shaped material having a width of 24 to 120 mm and a thickness of 0.15 to 0.25 mm. In the case where an insulating material is interposed between conductive materials, it is preferable that the inside and outside conductive materials are earthed.

As described above, various types of multi-layer structure of the cylindrical member can be thought of, and as in the case of the above-described embodiment, the passing-through of electromagnetic waves can be alleviated or shielded.

Also, for the cylindrical member, as shown in FIG. 15, a slit 32 is formed in the end part of the peripheral wall of a cylindrical member 31, and a protruding part corresponding to the slit 32 is formed on the outer peripheral surface of the end connection 18 shown in FIG. 6, by which the rotation of the cylindrical member 31 can be inhibited, and hence the cylindrical member 31 can be fixed surely.

Although the cylindrical member is formed so as to have a multi-layer structure, the cylindrical member can be formed in one layer of a metal only. For the one-layer cylindrical member, however, the thickness of metallic material is made large to keep its shape.

Further, as the conductive material, Mylar may be used in place of the carbon kraft paper. Also, the configuration may be such that an aerial wire and other harnesses for electrical equipment on the side on which noise is prevented are disposed in the cylindrical member 7 to prevent electromagnetic waves emitted from the outside from intruding.

In place of the use of metal foil, a metal coating may be applied onto the conductive material or the insulating material.

The present invention can be applied to not only general automobiles but also hybrid vehicles and vehicles using a fuel cell, which are under development, in the same way. For the electromagnetic waves emitted from a harness of electrical equipment used on ships and airplanes and at plants other than automobiles as well, the emission of electromagnetic waves can be alleviated by covering the harness with the cylindrical member in accordance with the present invention.

In the present invention, since the metallic cylindrical member is provided around the harness electrically connected to the electrical equipment, and the peripheral wall of the cylindrical member is formed in a corrugated shape in the axial direction, the electromagnetic waves emitted from the harness can be reflected on the cylindrical member and damped.

In the present invention, since the cylindrical member is provided with two or more layers on the inside and outside, and the layers are bonded with a conductive adhesive, the wall thickness of the cylindrical member can be increased. Since only a small amount of metallic material is used as a whole, the weight of cylindrical member can be reduced. Also, since the end connection can be brought into close contact with the wall because of increased wall thickness, the intrusion of high-frequency electromagnetic waves can be reduced.

In the present invention, the cylindrical end connection is formed at the pull-out port for harness of the electrical equipment, and the end part of the cylindrical member is fitted on the outer peripheral surface of the end connection, by which the harness and the pull-out port portion are connected to each other, so that the installation is easy to perform. Also, the leakage of electromagnetic waves from the connecting portion between the pull-out port portion and the cylindrical member can be prevented.

In the present invention, the cylindrical inside end connection is formed at the pull-out port for harness of the electrical equipment and the outside end connection is formed at the outer periphery of the inside end connection, and the end part of the cylindrical member is inserted between the inside end connection and the outside end connection, by which the harness and the pull-out port portion are connected to each other, so that the connection between the pull-out port and the end part of harness becomes firmer, by which the leakage of electromagnetic waves can be prevented.

In the present invention, the cylindrical member can be arranged at a curved place because of its flexibility.

In the present invention, by forming the cylindrical member of aluminum, the weight thereof can be reduced.

In the present invention, since the conductive adhesive is made of an epoxy, urethane, acrylic, or polyester resin, the conductivity of cylindrical member can further be improved.

In the present invention, since the cylindrical member is provided around the harness for connecting the battery for the electric vehicle to the inverter for converting the direct current into the alternating current or for connecting the inverter to the driving motor for the electric vehicle, the emission of electromagnetic waves from between the battery and the inverter or between the inverter and the driving motor for the electric vehicle to the outside can be prevented or alleviated.

## Claims

1. An electromagnetic wave shielding structure in which a cylindrical member is provided around a harness connected to electrical equipment, and a peripheral wall of said cylindrical member is formed in a corrugated shape in the axial direction.

2. The electromagnetic wave shielding structure according to claim 1, wherein said cylindrical member is made of a metal.

3. The electromagnetic wave shielding structure according to claim 1 or 2, wherein said cylindrical member is formed in a plurality of layers.

4. The electromagnetic wave shielding structure according to claim 3, wherein multilayer materials of said cylindrical member are bonded with a conductive adhesive.

5. The electromagnetic wave shielding structure according to any one of claims 1 to 4, wherein a cylindrical end connection is formed in a pull-out port portion for harness of said electrical equipment, and an end part of said cylindrical member is fitted on the outer peripheral surface of said end connection, by which said harness and said pull-out port portion are connected to each other.

6. The electromagnetic wave shielding structure according to any one of claims 1 to 4, wherein a cylindrical inside end connection and an outside end connection are formed in a pull-out port portion for harness of said electrical equipment, and an end part of said cylindrical member is inserted between said inside end connection and said outside end connection, by which said harness and said pull-out port portion are connected to each other.

7. The electromagnetic wave shielding structure according to any one of claims 1 to 6, wherein said cylindrical member has flexibility.

8. The electromagnetic wave shielding structure according to any one of claims 1 to 7, wherein said cylindrical member is made of aluminum.

9. The electromagnetic wave shielding structure according to any one of claims 4 to 8, wherein said conductive adhesive contains at least one kind of epoxy, urethane, acrylic, and polyester-based resins.

10. The electromagnetic wave shielding structure according to any one of claims 1 to 9, wherein said cylindrical member is provided around the harness for connecting a battery for an electric vehicle to an inverter for converting a direct current into an alternating current and/or for connecting the inverter to a driving motor for the electric vehicle.
